Europäisches Patentamt

**European Patent Office**

**Office européen des brevets**

(19)

(11) Veröffentlichungsnummer: **0 023 574**
**B1**

(12) **EUROPÄISCHE PATENTSCHRIFT**

(45) Veröffentlichungstag der Patentschrift:
10.10.84

(21) Anmeldenummer: 80103746.6

(22) Anmeldetag: 01.07.80

(51) Int. Cl.³: **G 01 R 31/28**, G 01 B 9/02,
G 06 K 9/00, G 06 K 9/46,
H 01 L 21/66

(54) **Opto-elektronisches Prüfsystem zur automatischen Beschaffenheitsprüfung von Leiterplatten, deren Zwischenprodukte und Druckwerkzeuge.**

(30) Priorität: 23.07.79 DE 2929846

(43) Veröffentlichungstag der Anmeldung:
11.02.81 Patentblatt 81/6

(45) Bekanntmachung des Hinweises auf die Patenterteilung:
10.10.84 Patentblatt 84/41

(84) Benannte Vertragsstaaten:
AT BE CH GB LI SE

(56) Entgegenhaltungen:
DE - A - 2 629 097
DE - A - 2 805 754

PROCEEDINGS OF THE FOURTH INTERNATIONAL
JOINT CONFERENCE ON PATTERN RECOGNITION,
7-10 November 1978 Kyoto, Japan N. GOTO et al. "An
Automatic Inspection System for Mask Patterns" Seiten
970 bis 974

(73) Patentinhaber: Siemens Aktiengesellschaft, Berlin und
München Wittelsbacherplatz 2, D-8000 München 2 (DE)

(72) Erfinder: Doemens, Günter, Dr., Föchingerstrasse 4,
D-8150 Holzkirchen (DE)
Erfinder: Hendricks, Ulrich, Dipl.-Ing.,
Josef-Doll-Strasse 18, D-8021 Neuried (DE)
Erfinder: Schneider, Richard, Dr., Leonhardiweg 21,
D-8024 Oberhaching (DE)
Erfinder: Wild, Karl, Dipl.-Ing., Inninger Strasse 27,
D-8900 Augsburg (DE)

BUNDESDRUCKEREI BERLIN

## Beschreibung

Die Erfindung betrifft ein opto-elektronisches Prüfsystem entsprechend dem Oberbegriff des Patentanspruches 1.

Zahlreiche Defekte an gedruckten Schaltungen (z. B. Leiterbahneinschnürungen) können nur über eine optische Beschaffenheitsprüfung gefunden werden. Bei der Kontrolle von Zwischenprodukten (z. B. Strukturen in entwickelten Fotoschichten) sowie bei Druckwerkzeugen ist man vollständig auf die Prüfung des optischen Bildes angewiesen.

Die Verkleinerung der Leiterbahngeometrien erschwert zunehmend eine Adaption für die elektrische Prüfung zur Lokalisierung von Kurzschlüssen und Unterbrechungen in den Leiterbahnen. Künftig werden auch diese elektrischen Prüfmethoden in einem weiten Bereich durch optische ersetzt werden müssen.

Die bisher eingesetzten visuellen Verfahren zur optischen Kontrolle dieser Strukturen gestalten sich aufgrund des personellen Aufwandes sehr kostenintensiv und können den steigenden Anforderungen an die Erkennungssicherheit nicht mehr gerecht werden.

In der Zeitschrift »Proceedings of the fourth International Joint Conference on Pattern Recognition«, 1978, ist auf den Seiten 970 bis 984 ein Aufsatz abgedruckt, in dem ein Prüfsystem entsprechend dem Oberbegriff des Anspruchs 1 beschrieben wird. In der Zeitschrift »Feinwerktechnik & Meßtechnik«, 84 (1976) 7, ist auf den Seiten 330 bis 334 der Aufsatz »Automatischer Vektordistanzkomparator VDK Projectina« abgedruckt. In diesem Aufsatz wird ein optischelektronisches Gerät beschrieben, mit welchem ebene Gegenstände mit großer geometrischer Figurendichte, wie z. B. Masken, Hybridschaltungen, Leiterplatten, Seriendrucke usw. durch Vergleich mit einem Urmuster (Master) automatisch auf Vollständigkeit und Kongruenz geprüft werden können. Derartige Vergleichsverfahren haben jedoch aufgrund der bei Leiterplatten auftretenden starken Reflexionsschwankungen sowie einem zulässigen Verzug im praktischen Einsatz erhebliche Nachteile. Ferner ist eine präzise Justierung der Prüflinge im Prüfsystem erforderlich. Zur Rationalisierung der visuell durchgeführten Prüfungen werden daher optische und opto-elektronische Hilfsmittel (z. B. Projektoren, TV-Kameras) eingesetzt.

Der Erfindung liegt die Aufgabe zugrunde, mit möglichst einfachen Mitteln ein automatisch arbeitendes opto-elektronisches Prüfsystem zu konzipieren, das universell einsetzbar ist (für Leiterplatten, deren Zwischenprodukte sowie Druckwerkzeuge) und eine deutliche Verringerung der Prüfkosten bei gleichzeitiger Erhöhung der Erkennungssicherheit gewährleistet.

Diese Aufgabe wird durch den Gegenstand des Anspruchs 1 gelöst.

Das vorgeschlagene Verfahren beruht nicht auf einem Vergleichsverfahren mit einem Musterprüfobjekt, sondern auf einer Absolutprüfung anhand von musterspezifischen Prüfkriterien. Zur Auffindung der überwiegenden Anzahl von Fehlerarten ist daher ein bildpunktweiser Vergleich mit einem abgespeicherten Soll-Muster oder einem körperlichen Master nicht erforderlich.

Mit der Lösung nach der Erfindung ist es aber auch möglich, die geringen und schwankenden Kontraste der Oberflächen (insbesondere bei Strukturen in entwickelten Fotoschichten und Bearbeitungsspuren auf den metallischen Oberflächen) sowie die hohe Informationsmenge in kurzer Zeit zu verarbeiten (insbesondere bei hohen Strukturdichten).

Ausgestaltungen der Erfindung ergeben sich aus den Unteransprüchen.

Die analoge Signalvorverarbeitung wird durch ladungsgekoppelte Schieberegister realisiert. Gegenüber einer digitalen Signalverarbeitung hat das den Vorteil, daß der Bauteilaufwand wesentlich reduziert wird.

Zunächst erzeugt die analoge Signalvorverarbeitung durch die Differenzierung des Bildes eine Kantenstruktur mit aufsteigenden und abfallenden Kanten, die durch eine vierdimensionale Differenzbildung, z. B. in einem Feld von $6 \times 6$ zwischengespeicherten analogen Bildpunkten, gewonnen wird, wobei je Richtung mehrere Differenzen mit unterschiedlichen Gewichtungen zusammengefaßt werden und aus den verschiedenen untersuchten Richtungen das betragsmäßig größte Ergebnis dieser Operation dem Zentrum dieses Feldes zugeordnet wird. Dadurch erhält man bei texturbehafteten Oberflächen eine Unterdrückung von lokalen Kontrasteinbrüchen.

Aus der Kantenstruktur wird eine Rekonstruktion des binären Bildes erzeugt. Die Rekonstruktion des binären Bildes erfolgt durch Extremwerterkennung vom Differenzsignal in unterschiedlichen Richtungen sowie durch eine Zuordnung dieser Einzelergebnisse unter Einbeziehung örtlich vorausgegangener Ereignisse. Auf diese Weise wird eine Vereinfachung der Bildauswertung erreicht.

Die parallel arbeitenden Fehlererkennungsschaltungen umfassen eine Minimalgeometrieprüfung, eine Prüfung von größeren zusammenhängenden Flächenelementen, z. B. Lötaugen, auf Einhaltung von Form und Fläche und ferner die Erkennung zweier spezifischer Geometrien, z. B. Leiterbahnunterbrechung und Kurzschluß zwischen benachbarten Leitern. Auf diese Weise werden sämtliche auftretenden Fehler erkannt. Für die vollständige Untersuchung eines Prüflings ist nur ein Durchlauf erforderlich.

In jedem Bildpunkt wird eine Überprüfung der Strukturelemente bezüglich deren Abmessungen in mehreren Richtungen und entsprechend der Klassenzugehörigkeit des Bildpunktes ein Vergleich dieser Ergebnisse mit den zulässigen Minimalgeometrien dieser Musterklasse durchgeführt und diese zugehörige Minimalgeometrie austauschbar gestaltet. Unter der Voraussetzung, daß der Bildinhalt z. B. in zwei Klassen, nämlich schwarz und weiß zerlegt wird, ist ein schwarzer Bildpunkt der Musterklasse schwarz (z. B. Isolation) und ein weißer Bildpunkt der Musterklasse weiß (z. B. Metallisierung) zuzuordnen. Diese Lösung bietet ein sicheres Erkennungskriterium für häufig vorkommende Fehlerarten.

Die am Eingang der Minimalgeometrieprüfung beispielsweise binär anstehende Bildinformation wird in einem Feld von vorzugsweise 10 × 10 Bildpunkten zwischengespeichert. Damit wird ein zeitlich paralleler Zugriff zu den einzelnen Bildpunkten geschaffen.

Das in mehreren, vorzugsweise vier Richtungen, vorliegende eindimensionale Muster zur Durchführung der Minimalgeometrieprüfung wird hinsichtlich zusammenhängender Punktfolgen untersucht, ob deren Länge die zulässige Minimalgeometrie unterschreitet und eine Fehlermeldung nur dann ausgelöst, wenn die Unterschreitung der Minimalgeometrien gleichzeitig in mehreren, vorzugsweise zwei, benachbarten Raumrichtungen auftritt. Dadurch erreicht man, daß durch die Auswertung der Ergebnisse benachbarter Raumrichtungen innerhalb des 10 × 10 Feldes eine Unterdrückung des Ansprechverhaltens dieser Fehlererkennung auf reguläre Randstrukturen stattfindet.

Bei der Lötaugenprüfung (2. Fehlererkennungsschaltung) und bei der Erkennung zweier spezieller Geometrien (Erkennung von Kurzschlüssen oder Unterbrechungen) ist eine elektronische Auflösungsreduktion vorgeschaltet. Der wesentliche Vorteil dieser Lösung besteht darin, daß bei einem Durchlauf gleichzeitig die Untersuchung des Prüflings mit unterschiedlicher geometrischer Genauigkeit erfolgen kann. Im Gegensatz zur optischen Auflösungsreduktion ist bei der elektronischen Auflösungsreduktion nur ein Durchlauf erforderlich.

Zur Auflösungsreduktion wird beispielsweise ein 4 × 4 Feld aus Schieberegistern aufgebaut und die Summe aus dessen Einzelelementen als Bewertungskriterium für den vorzugsweise benären Wert eines neuen, repräsentativen Bildpunktes herangezogen.

Die Lötaugenprüfung wird in zwei Stufen durchgeführt, und zwar einer Erkennung der Lötaugen aufgrund deren spezifischer Form durch Mustervergleich und im Fall, daß die Erkennung ein positives Ergebnis liefert, die Prüfung des Lötauges auf Vorhandensein der Metallisierung an definierten Stellen, woraus die Vollständigkeit der Lötaugengeometrie abgeleitet wird.

Die Lötaugenprüfung kann beispielsweise in einem 15 × 15 Bildpunkte umfassenden Feld mit parallelem Abgriff, das durch eine Kombination von digitalen Schieberegistern realisiert ist, durchgeführt werden. Der Mustervergleich kann beispielsweise mit bekannten Korrelationsverfahren bewältigt werden.

Für die Auffindung langer Leiterbahnunterbrechungen wird ein 3 × 3 Feld mit parallelem Zugriff durch die Kombination von digitalen Schieberegistern erzeugt und nur dann eine Fehlermeldung ausgelöst, wenn nur der Mittelpunkt oder nur dieser und ein weiterer Punkt des Feldes einer Leiterbahn zugeordnet werden kann.

Um Kurzschlüsse, z. B. zwischen Leiterbahnen, zu finden, die länger sind als die nominelle Leiterbahnbreite, kann z. B. ein Feld von 5 × 5 Bildpunkten mit parallelem Zugriff durch die Kombination von digitalen Schieberegistern erzeugt werden und durch eine Korrelation mit einem Fehlermuster, das in 8 Winkelorientierungen vorliegt, verglichen werden und bei voller Übereinstimmung eine Fehlermeldung abgeleitet werden.

Um den Zusammenhang zwischen Fehlermeldung und Fehlerort herzustellen, ist eine Fehlerverwaltung vorgesehen, in der die aus den verschiedenen parallel arbeitenden Fehlererkennungsschaltungen kommenden Fehlermeldungen nach entsprechender Laufzeitkorrektur über die vorhandenen Wegmeßsysteme mit den zugehörigen Koordinaten ihres jeweiligen Ortes im Leiterbild zugeordnet werden.

In der Fehlerverwaltungsschaltung findet eine Fehlerverdichtung statt, die örtlich eng benachbarte Einzelfehlermeldungen zu einem Gesamtfehler entsprechend des zur visuellen Klassifizierung zur Verfügung stehenden Gesichtsfeldes zusammenfaßt. Auf diese Weise wird erreicht, daß Defekte, die sich über mehrere Bildpunkte erstrecken und daher mehrere Fehlermeldungen liefern, zu einer Fehlermeldung zusammengefaßt werden, so daß der Fehler selbst auch als Gesamtfehler erkannt wird.

In der Fehlerverwaltungsschaltung werden die während des Prüflaufs anfallenden Fehlerkoordinaten gespeichert, um anschließend bei der visuellen Klassifizierung verwendet zu werden.

Zur Bewegung des Kreuztisches ist eine Ablaufsteuerung vorgesehen, die während der Prüfung den Prüfling mäanderförmig mit konstanter Geschwindigkeit unter der Optik verschiebt und anschließend bei der visuellen Klassifizierung den Fehlerort entsprechend den in der Fehlerverwaltung gespeicherten Fehlerkoordinaten im Gesichtsfeld der Optik positioniert.

Bei der visuellen Betrachtung können durch Tastenbetätigung über die Ablaufsteuerung die Fehler entsprechend einer bestimmten Reihenfolge betrachtet werden. Vorzugsweise kann der Fehlerort im Gesichtsfeld der Optik über einen TV-Monitor entsprechend vergrößert betrachtet werden. Der Arbeitsabstand zwischen Prüfling und Optik ist ferner ausreichend groß zur Reparatur der Fehlerstelle. Außerdem kann auch ein Markierungsautomat zur automatischen Markierung des Fehlerortes auf dem Prüfling angeschlossen werden.

Die Erfindung wird anhand der Figuren erläutert. Es zeigt

Fig. 1 ein schematisches Systemkonzept einer automatischen Leiterplattenprüfung,

Fig. 2 die Differenzbildung in der analogen Signalvorverarbeitung,

Fig. 3 die Extremwertbildung in der analogen Signalvorverarbeitung,

Fig. 4 die Minimalgeometrieprüfung,

Fig. 5 die Auflösungsreduktion,

Fig. 6 die Lötaugenprüfung und

Fig. 7 die Prüfung auf langen Kurzschluß und lange Leiterbahnunterbrechung.

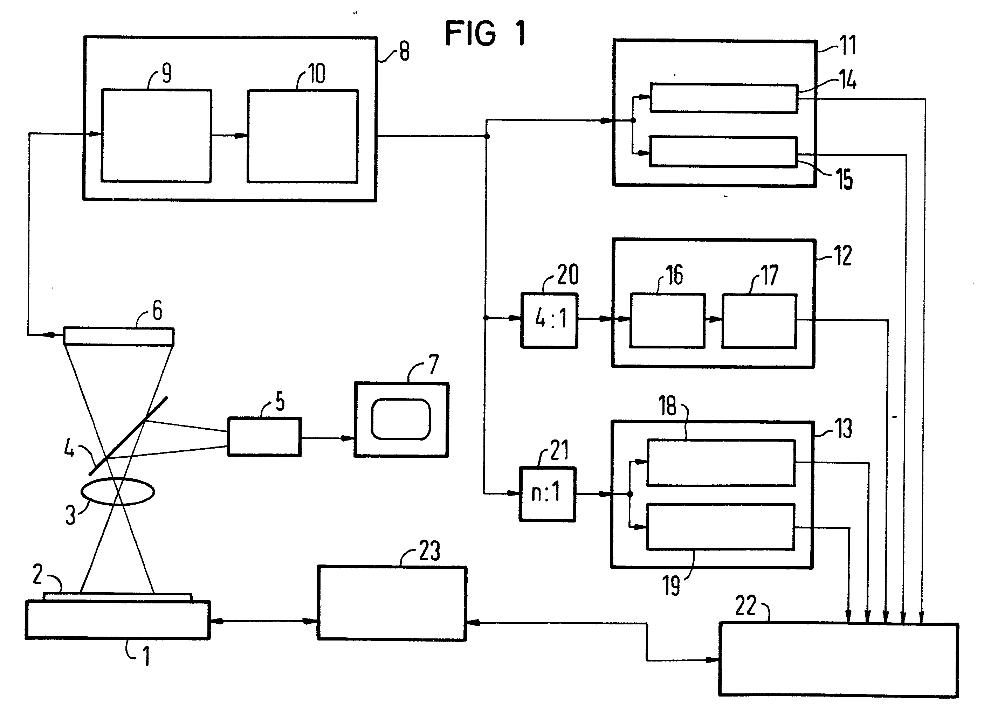

In der Fig. 1 ist auf einem Kreuztisch 1 ein Prüfling 2 befestigt, über dem sich eine Optik 3 befindet. Über der Optik ist ein Spiegel 4 vorgesehen, der das vom Prüfling reflektierte Licht einer nicht dargestellten Lichtquelle auf eine TV-Kamera 5 und einen Bildwandler 6 aufteilt. An die TV-Kamera 5 schließt sich ein TV-Monitor 7 an.

Der Bildwandler 6 besteht beispielsweise aus einem Halbleiterbildwandler in Zeilenform mit 256 Bildpunkten. Das Signal vom Bildwandler wird zuerst einer analogen Signalvorverarbeitung 8, die eine Differenzbildung 9 und eine Extremwertbestimmung 10 umfaßt, zugeführt. Von der analogen Signalvorverarbeitung kommt das Signal zu mehreren parallel arbeitenden Fehlererkennungsschaltungen, die eine Minimalgeometrieprüfung 11, eine Lötaugenprüfung 12 und eine Prüfung auf Spezialgeometrien 13 umfassen. Zur Minimalgeometrieprüfung 11 gehört eine Prüfung auf Leiterbahnbreite 14 und eine Prüfung auf Isolationsbreite 15. Die Lötaugenprüfung 12 umfaßt eine Erkennung 16 und eine Vermessung 17. Zu den Spezialgeometrien 13 gehört die Prüfung auf langen Kurzschluß 18 und auf lange Unterbrechung 19. Vor der Lötaugenprüfung 12 und der Prüfung auf Spezialgeometrien 13 ist eine Auflösungsreduktion 20 und 21 vorgeschaltet. Die Ausgänge der parallel arbeitenden Fehlererkennungsschaltungen 11 bis 13 führen auf eine Fehlerverwaltung 22. Die in der Fehlerverwaltung 22 abgelegten Fehlerkoordinaten stehen einer Ablaufsteuerung 23 zur Verfügung, die den Kreuztisch 1 ansteuert.

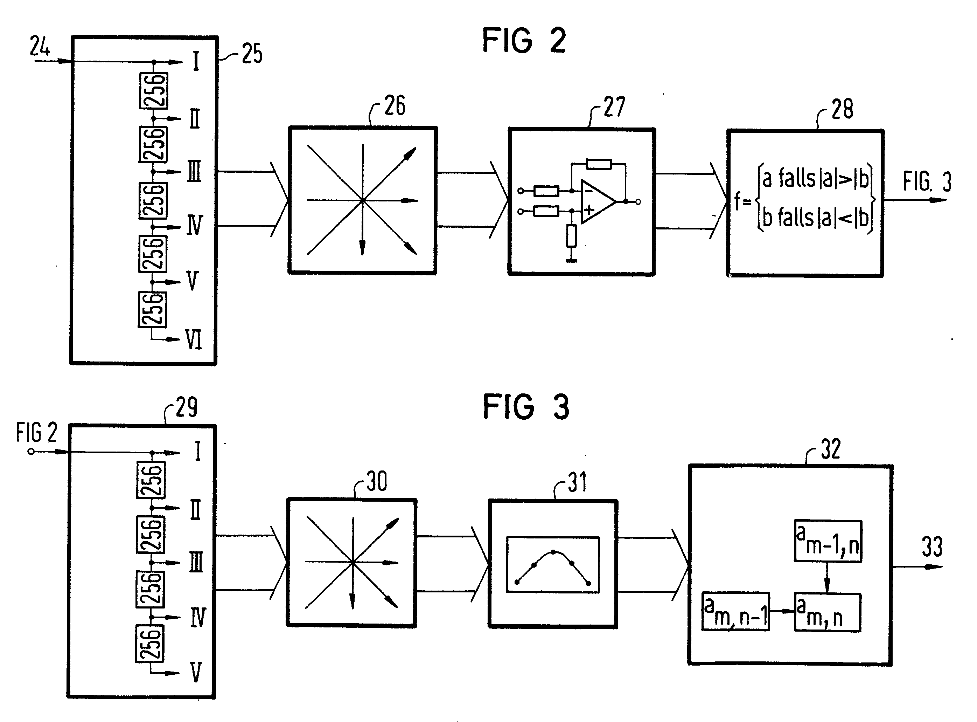

Die Fig. 2 zeigt die Differenzbildung der analogen Signalvorverarbeitung. Das vom Bildwandler kommende Signal 24 wird durch eine Anordnung von analogen Schieberegistern 25 (z. B. CCD-Schieberegister) zeilenweise verzögert. Die einzelnen Schieberegister haben eine Länge von beispielsweise 256 Bildpunkten. Die Ausgänge I bis VI dieser Schieberegister werden über getrennte Leitungen zu einem $6 \times 6$ Bildfeld 26 geführt. Dieses Bildfeld wird erzeugt durch eine punktweise Verzögerung der Signale I bis VI in Spaltenrichtung. Aus diesem Feld werden 20 Punkte ausgewählt, die zu den vier dargestellten Raumrichtungen gehören, und über 20 getrennte Leitungen einer Differenzbildung 27 zugeführt. Hier werden entsprechend den in 26 dargestellten 4 Raumrichtungen $4 \times 1$ analog gewichtete Differenzbildungen über 6 Bildpunkte durchgeführt und über 4 getrennte Leitungen einer Maximalauswahl 28 zugeleitet. In dieser Maximalauswahl werden entsprechend der dargestellten Funktion aus den 4 angebotenen Ergebnissen der Differenzbildung des betragsmäßig größte ausgewählt.

An die Maximalauswahl 28 schließt sich die in der Fig. 3 dargestellte Extremwertbildung an. Das von der Fig. 2 kommende Signal wird durch eine Anordnung von Analogschieberegistern 29 (z. B. CCD-Schieberegister) zeilenweise verzögert. Die einzelnen Schieberegister haben eine Länge von beispielsweise 256 Bildpunkten. Die Ausgänge I bis V dieser Schieberegister werden über 5 getrennte Leitungen zu einem $5 \times 5$ Bildfeld 30 geführt. Dieses Bildfeld wird durch eine punktweise Verzögerung der Signale I bis V in Spaltenrichtung erzeugt. Aus diesem Feld werden 17 Punkte ausgewählt, die zu den 4 dargestellten Raumrichtungen gehören und über 17 getrennte Leitungen einer Extremwerterkennung 31 zugeführt. Hier wird entsprechend den in dem Feld 30 dargestellten 4 Raumrichtungen eine Extremwerterkennung durchgeführt und die Ergebnisse über 4 getrennte Leitungen einer Verknüpfung 32 zugeführt. In der Verknüpfung 32 werden die von 31 angebotenen Extremwerte mit den Ergebnissen aus in Zeilenrichtung $(a_{m, n-1})$ und Spaltenrichtung $(a_{m-1, n})$ vorausgegangenen Punkten verknüpft und daraus ein binäres Bild $(a_{m, n})$ erzeugt, das über die Leitung 33 weitergegeben wird.

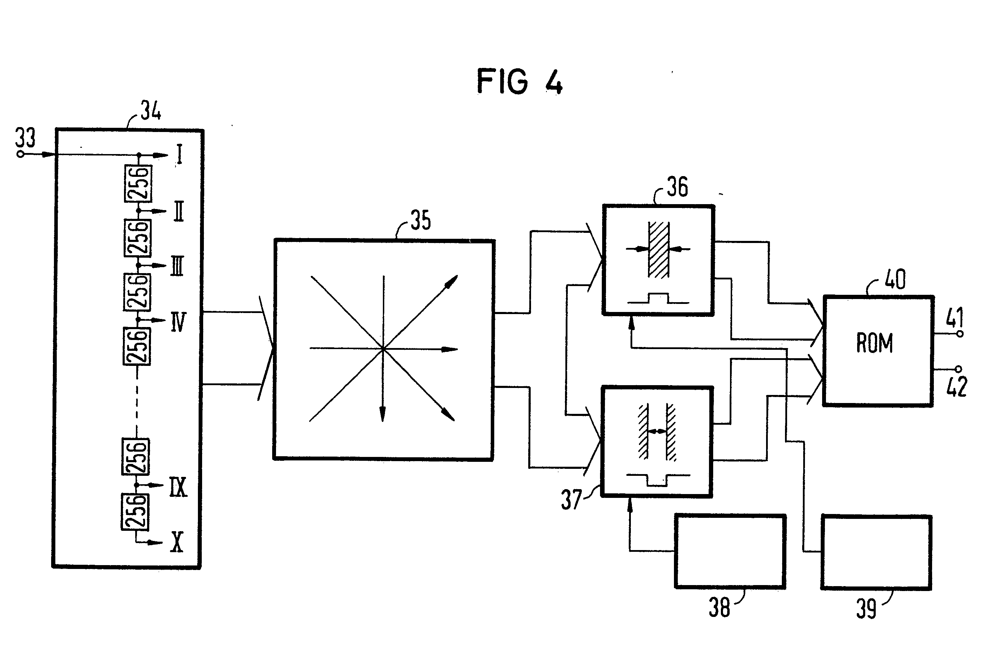

Nach der Darstellung in der Fig. 4 wird das Signal von der Leitung 33 durch eine Anordnung von digitalen Schieberegistern 34 (z. B. TTL-Schieberegister) zeilenweise verzögert. Die einzelnen Schieberegister haben eine Länge von beispielsweise 256 Bildpunkten. Die Ausgänge I bis X dieser Schieberegister werden über getrennte Leitungen zu einem $10 \times 10$ Feld 35 geführt. Dieses Bildfeld wird erzeugt durch eine punktweise Verzögerung der Signale I bis X in Spaltenrichtung. Aus diesem Feld werden 24 Punkte ausgewählt, die zu den vier dargestellten Raumrichtungen gehören und über 24 getrennte Leitungen einer Untersuchung von Leiterbahnbreite 36 und einer Untersuchung auf Isolationsbreite 37 zugeführt. Hier werden entsprechend den in 38 (Isolation) und 39 (Leiterbahn) eingestellten Minimalmaßen die aus 35 angebotenen Signale entsprechend der in 35 dargestellten 4 Raumrichtungen in ihrer Länge angepaßt. Die schematische Darstellung in 36 und 37 stellt die Verfahren der Untersuchung auf minimale Länge von zusammenhängenden Punktfolgen dar. Die in 36 und 37 umformatierten Signale, die eine Maximallänge von 10 Bildpunkten umfassen und nacheinander in den 4 in 35 dargestellten Raumrichtungen durchgeschaltet werden, werden auf einen Vergleichsspeicher 40 (z. B. ROM) geschaltet. Am Ausgang von 40 findet man dann die Fehlermeldungen für die Unterscheidung der Minimalgeometrien in Kupfer 41 und Isolation 42 vor.

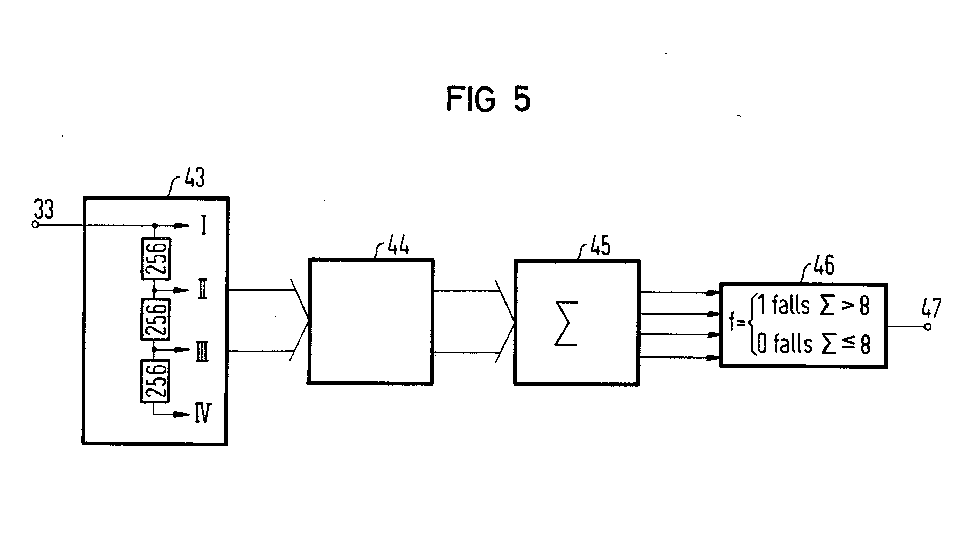

Nach der Fig. 5 wird das binäre Signal 33 durch eine Anordnung von digitalen Schieberegistern 43 (z. B. TTL-Schieberegistern) zeilenweise verzögert. Die einzelnen Schieberegister haben eine Länge von beispielsweise 256 Bildpunkten. Die Ausgänge I bis IV dieser Schieberegister werden über getrennte Leitungen zu einem $4 \times 4$

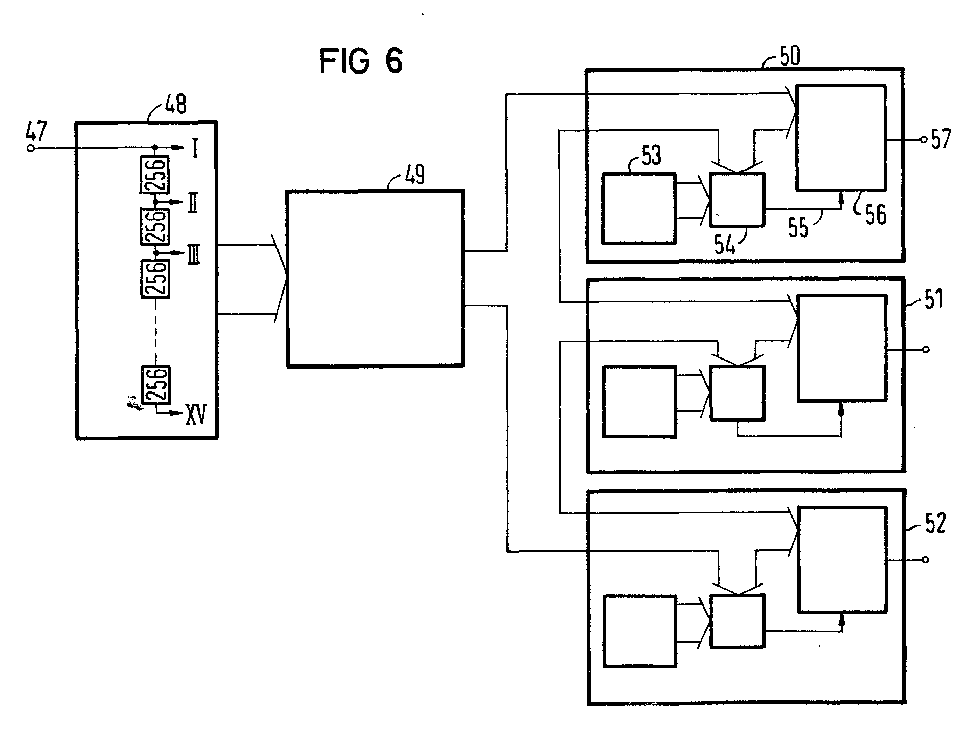

Feld 44 geführt. Dieses Bildfeld wird erzeugt durch eine punktweise Verzögerung der Signale I bis IV in Spaltenrichtung. Die 16 Bildpunkte dieses Feldes werden über 16 getrennte Leitungen einer Summenbildung 45 zugeführt. Das Ergebnis der Summe geht auf einen Komparator 46, der entsprechend der dargestellten Funktion das Ausgangssignal 47 liefert. Dieses Signal ist das Ergebnis der Auflösungsreduktion, die wiederum einem Schieberegister 48 (Fig. 6) zugeführt wird.

Durch die Anordnung der Digitalschieberegister 48 (z. B. TTL-Schieberegister) wird dieses Signal zeilenweise verzögert. Die einzelnen Schieberegister haben eine Länge von beispielsweise 256 Bildpunkten. Die Ausgänge I bis XV dieser Schieberegister werden über getrennte Leitungen zu einem 15 × 15 Feld 49 geführt. Dieses Bildfeld wird durch eine punktweise Verzögerung der Signale I bis XV in Spaltenrichtung erzeugt. Aus diesem Feld werden die Bildpunkte über getrennte Leitungen zu beispielsweise 3 parallel arbeitenden Fehlererkennungsschaltungen 50 bis 52 geführt. In der Erkennungsschaltung 50 ist ein Referenzmuster 53 für eine Lötaugentype A abgelegt. Dieses Signal wird mit den Bildpunkten aus 49 in einem Korrelator 54 verglichen und daraus das Erkennungssignal 55 für den Lötaugentyp A abgeleitet. Dieses steuert eine Lötaugenvermessung 56 für den Typ A, wo das Vorhandensein von Metallisierung an bestimmten Stellen des Lötauges überprüft wird. Die Lötaugenvermessung liefert ein Fehlersignal 57. Die zwei weiteren Fehlererkennungsschaltungen 51 und 52 arbeiten nach dem gleichen Verfahren; deren Erkennungs- und Vermessungsschaltung sind aber auf andere Lötaugentypen eingestellt.

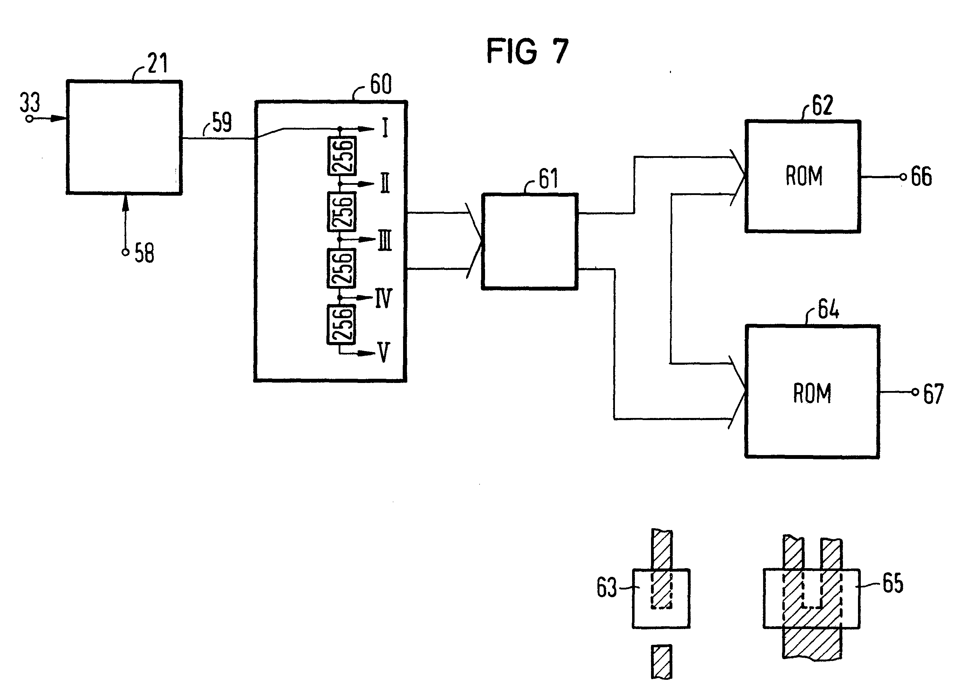

Nach der Fig. 7 kommt das binäre Signal 33 zu einer programmierbaren Auflösungsreduktion 21, die in ihrem Prinzip der in Fig. 5 dargestellten Auflösungsreduktion 20 entspricht. Diese Auflösungsreduktion wird durch die Minimalmaße der Leiterbahnbreite 58 gesteuert. Der Ausgang 59 führt auf eine Anordnung von digitalen Schieberegistern 60 (z. B. TTL-Schieberegister). Die einzelnen Schieberegister haben eine Länge von beispielsweise 256 Bildpunkten. Die Ausgänge I bis V dieser Schieberegister werden über getrennte Leitungen zu einem 5 × 5 Feld 61 geführt. Dieses Bildfeld wird erzeugt durch eine punktweise Verzögerung der Signale I bis V in Spaltenrichtung. Aus diesem Feld wird der innere Bereich von 9 Bildpunkten einem Vergleichsspeicher 62 (z. B. ROM), zugeführt, in dem das Fehlermuster 63 (Leiterbahnunterbrechung) in 8 Richtungen abgelegt ist. Aus dem Feld 61 wird ferner der Gesamtinhalt von 25 Bildpunkten einem weiteren Vergleichsspeicher 64 zugeleitet, in dem das Fehlermuster 65 (Kurzschluß) in 8 Richtungen abgelegt ist. An den Ausgängen 66 und 67 erscheinen die entsprechenden Fehlersignale.

Im folgenden wird ein Prüfablauf im wesentlichen beschrieben:

Zuerst wird bei Beginn einer Prüfserie dem Automaten ein Prüfnutzen, d. h. das Format der zu prüfenden Oberfläche, über eine bestimmte Prozedur eingegeben. Diese besteht darin, daß der Prüfling 2 eingelegt und dessen Umrandung mit dem Meßkopf manuell abgefahren wird. Der Prüfnutzen ist damit für alle weiteren Prüfungen dieser Serie festgelegt. Damit kann ein Prüflauf gestartet werden, der darin besteht, daß der Prüfling mäanderförmig unter der Optik verfahren wird. Am Ende des Prüflaufs fährt der Kreuztisch automatisch die erste Fehlerposition an und der Fehler selbst wird auf dem Monitor in vergrößerter Form sichtbar. Alle weiteren gespeicherten Fehler können zur visuellen Beurteilung durch Tastenbetätigung automatisch angefahren werden. Nach Beurteilung sämtlicher Fehler kehrt der Kreuztisch in seine Nullstellung zurück, so daß der nächste Prüfling eingelegt werden kann.

Eine automatische Unterscheidung dieser Fehlermeldungen von elektrisch relevanten Fehlern ist sehr aufwendig und könnte unter Umständen die Erkennungssicherheit wieder reduzieren.

Aus diesem Grund werden die gefundenen Fehler nach Ablauf der automatischen Prüfung einer visuellen Klassifizierung unterzogen. Hierzu erfolgt eine Verdichtung der Fehleranzahl durch Zusammenfassung von eng benachbarten Fehlern entsprechend des zur visuellen Klassifizierung zur Verfügung stehenden Gesichtsfeldes.

Mit den aus der Verdichtung entstandenen Fehlerkoordinaten wird der Kreuztisch mit dem Prüfobjekt so angesteuert, daß die gefundenen, fehlerwahrscheinlichen Bereiche im Gesichtsfeld einer Betrachtungseinrichtung, vorzugsweise einer Fernsehkamera, automatisch positioniert werden.

**Patentansprüche**

1. Opto-elektronisches Prüfsystem zum Erkennen von Fehlern in Leiterbahnmustern von Prüfobjekten in Form von Leiterplatten oder bei der Herstellung dieser Leiterplatten entstehenden Vorstufen sowie den hierbei verwendeten Druckwerkzeugen, mit

— einem Bildwandler (6), wie zum Beispiel einer Fotodiodenzeile,
— einem Objektiv (3) zur Abbildung eines Bereichs des Prüfobjekts (2) auf dem Bildwandler (6),
— einem das Prüfobjekt (2) tragenden Kreuztisch (1) zur mäanderförmigen Verschiebung des Prüfobjekts (2) mit konstanter Geschwindigkeit relativ zum Bildwandler (6),
— mit einem dem Kreuztisch (1) zugeordneten Wegmeßsystem,
— mit einer Schaltung zur Erzeugung eines seriellen, binären Bildsignals aus dem Ausgangssignal des Bildwandlers (6), welche Schaltung eine analoge Signalvorverarbeitung (8) einschließt,
— sowie mit einer Anzahl von parallel zueinander an den Ausgang der Schaltung (8) angeschlossenen Fehlererkennungsschaltungen (11, 12, 13),

gekennzeichnet durch

a)  eine erste Fehlererkennungsschaltung (11) zur Durchführung einer Minimalgeometrieprüfung durch Erkennung von Fehlern in den Leiterbahnbreiten und den Isolationsabständen, welche folgende Einrichtungen aufweist:

(i)  eine von dem Bildsignal beaufschlagte erste Speichereinrichtung (35), in deren Speicherplätzen den Punkten eines Ausschnitts des Leiterbahnmusters zugeordnete Bildsignaldaten in zweidimensionaler, dem betrachteten Ausschnitt entsprechender Anordnung abspeicherbar sind,

(ii)  Einrichtungen zum parallelen Auslesen der in der ersten Speichereinrichtung (35) entlang unterschiedlicher Speicherfeldrichtungen vorhandenen Bildsignaldaten,

(iii)  erste Vergleichseinrichtungen (36—40) zum Vergleich der entlang jeder Richtung ausgelesenen Bildsignaldaten mit vorgegebenen Datenfolgen,

b)  eine zweite Fehlererkennungsschaltung (12) zur Erkennung fehlerhafter Lötaugen, welche folgende Einrichtungen aufweist:

(iv)  eine ebenfalls vom Bildsignal beaufschlagte, der ersten Speichereinrichtung entsprechende zweite Speichereinrichtung (49),

(v)  zweite Vergleichseinrichtungen (54) zur Erkennung des Vorhandenseins eines Lötauges durch Vergleich der in der zweiten Speichereinrichtung (49) enthaltenen Bildsignaldaten mit vorgegebenen, fehlerfreie Lötaugen unterschiedlichen Typs repräsentierenden Datenmustern,

(vi)  Einrichtungen (56) zum Überprüfen erkannter Lötaugen auf Form und Fläche anhand der in der zweiten Speichereinrichtung (49) enthaltenen Bildsignaldaten,

c)  eine dritte Fehlererkennungsschaltung (13) zum Erkennen von Kurzschlüssen (65) oder Unterbrechungen (63), deren Ausdehnung größer als die minimale Leiterbahnbreite bzw. der minimale Isolationsabstand ist, welche folgende Einrichtungen umfaßt:

(vii)  eine vom Bildsignal beaufschlagte, der ersten bzw. zweiten Speichereinrichtung (35 bzw. 49) entsprechende dritte Speichereinrichtung (61),

(vu)  eine dritte Vergleichseinrichtung (62, 64) zum Vergleich der Bildsignaldaten in der dritten Speichereinrichtung (61) mit vorgegebenen Datenmustern, welche für Kurzschlüsse bzw. Unterbrechungen in unterschiedlich orientierten Leiterbahnen repräsentativ sind,

d)  eine die Fehlermeldungen der Fehlererkennungsschaltungen (11, 12, 13) übernehmende Fehlerverwaltungsschaltung (22) mit einem Speicher zur Aufnahme der beim Auftreten einer Fehlermeldung vom Wegmeßsystem gelieferten Koordinatenwerte,

e)  eine Steuerschaltung (23) mittels der der Kreuztisch (1) in den Koordinaten der Fehlermeldungen entsprechende Positionen verfahrbar ist, sowie

f)  eine Betrachtungseinrichtung (7) zur Sichtbarmachung der den genannten Positionen entsprechenden Bereiche des Prüfobjektes.

2.  Prüfsystem nach Anspruch 1, dadurch gekennzeichnet, daß der zweiten sowie der dritten Fehlererkennungsschaltung (12 bzw. 13) jeweils eine elektronische Auflösungsreduktion (20 bzw. 21) vorgeschaltet ist.

3.  Prüfsystem nach Anspruch 2, dadurch gekennzeichnet, daß zur Auflösungsreduktion beispielsweise ein 4 × 4 Feld aus Schieberegistern (44) vorgesehen ist, wobei die Summe (45) aus dessen Einzelelementen einen reduzierten Bildpunkt vorzugsweise als binären Wert repräsentiert.

4.  Prüfsystem nach Anspruch 1, dadurch gekennzeichnet, daß für die Auffindung langer Leiterbahnunterbrechungen die dritte Speichereinrichtung ein 3 × 3 Feld aufweist, das parallelen Zugriff zu einer Kombination von mit dem Bildsignal beaufschlagten digitalen Schieberegistern (60) hat und die dritte Vergleichseinrichtung so ausgebildet ist, daß nur dann eine Fehlermeldung erfolgt, wenn nur der Mittelpunkt oder wenn nur dieser und ein weiterer Punkt des Feldes einer Leiterbahn zugeordnet werden kann.

5.  Prüfsystem nach Anspruch 1, dadurch gekennzeichnet, daß für das Erkennen von langen Kurzschlüssen die dritte Speichereinrichtung ein Feld von 5 × 5 Bildpunkten aufweist, das parallelen Zugriff zu einer Kombination von mit dem Bildsignal beaufschlagten digitalen Schieberegistern (60) hat und daß die dritte Vergleichseinrichtung so ausgebildet ist, daß eine Korrelation mit einem Fehlermuster, das in 8 Winkelorientierungen vorliegt, durchgeführt und bei vollständiger Übereinstimmung eine Fehlermeldung (67) abgegeben wird.

6.  Prüfsystem nach Anspruch 1, dadurch gekennzeichnet, daß in der Fehlerverwaltungsschaltung (22) eine Fehlerverdichtung stattfindet, die örtlich eng benachbarte Einzelfehlermeldungen zu einem Gesamtfehler entsprechend des zur visuellen Klassifizierung zur Verfügung stehenden Gesichtsfeldes zusammenfaßt.

7. Prüfsystem nach Anspruch 1, dadurch ge kennzeichnet, daß bei der visuellen Klassifizierung durch Tastenbetätigung über die Ablaufsteuerung (23) die Fehler entsprechend einer bestimmten Reihenfolge betrachtet werden können.

## Claims

1. An opto-electronic test system for recognition of faults in conductor path patterns of objects to be tested, which objects are in the form of circuit boards or intermediate products formed during production of circuit boards and printing tools used for this purpose, comprising:

— an image converter (6) such as a row of photo-diodes,
— an objective (3) to focus onto the image converter (6) a zone of the test object (2),
— a cross-desk (1) which bears the test object (2) and serves to effect a serpentine displacement of the test object (2) at a constant speed relative to the image converter (6),
— with a path measuring system assigned to the cross-desk (1),
— with a circuit which serves to generate a serial, binary image signal from the output signal of the image converter (6), which circuit includes an analogue signal preliminary processing unit (8),
— and with a number of fault recognition circuits (11, 12, 13) connected in parallel to the output of the circuit (8),

characterised by

a) a first fault recognition circuit (11) to effect a minimal geometry test by recognition of faults in the conductor path widths and the insulation spacings, which circuit includes the following devices:

(i) a first storage device (35) supplied with the image signal and whose storage locations can store items of image signal data assigned to the points of a portion of the conductor path pattern in a two-dimensional arrangement corresponding to the portion under observation,
(ii) devices for parallel read-out of the items of image signal data contained in the first storage device (35) along different storage array directions,
(iii) first comparison devices (36—40) which serve to compare the items of image signal data read-out along each direction with predetermined data sequences;

b) a second fault recognition circuit (12) for the recognition of faulty soldering lugs, which circuit includes the following devices:

(iv) a second storage device (49) which corresponds to the first storage device and is supplied with the image signal,
(v) second comparison devices (54) for recognising the presence of a soldering lug by comparing the items of image signal data contained in the second storage device (49) with predetermined data patterns representative of fault-free soldering lugs of different types,
(vi) devices (56) for testing recognised soldering lugs in terms of shape and area on the basis of the items of image signal data contained in the second storage device (49);

c) a third fault recognition circuit (13) for the recognition of short-circuits (65) or interruptions (63) the extent of which exceeds the minimum conductor path widths or the minimum insulation spacing, which circuit includes the following devices:

(vii) a third storage device (61) which corresponds to the first and the second storage devices (35 and 49) and is supplied with the image signal,
(vu) a third comparison device (62, 64) for comparing the items of image signal data in the third storage device (61) with predetermined data patterns which are representative of short-circuits and interruptions in differently orientated conductor paths,

d) a fault administration circuit (22) which receives the fault messages from the fault recognition circuits (11, 12, 13) and which includes a store for the accomodation of the coordinate values supplied on the occurrence of a fault message by the path measuring system;

e) a control circuit (23) by means of which the cross-table (1) can be moved into positions corresponding to the coordinates of the fault messages; and

f) an observation device (7) which serves to visualise those zones of the test object which correspond to the aforementioned positions.

2. A test system as claimed in claim 1, characterised in that the second and the third fault recognition circuits (12, 13) are each preceded by an electronic resolution reduction unit (20 and 21).

3. A test system as claimed in claim 2, characterised in that a 4 × 4 array of shift registers (44) is provided for resolution reduction, for example, where the sum (45) of the individual elements thereof represents a reduced image point, preferably in the form of a binary value.

4. A test system as claimed in claim 1, characterised in that in order that long conductor path interruptions may be discovered the third storage device possesses a 3 × 3 array which has parallel access to a combination of digital shift registers (60) supplied with the image signal, and the third comparison device is designed to be such that a fault message is given only when only the central point or else the central point and one further point of the array can be assigned to a conductor path.

5. A test system as claimed in claim 1, characterised in that in order that long short-circuits may be recognised the third storage device possesses an array of 5 × 5 image points which possesses parallel access to a combination of digital shift registers (60) supplied with the image signal, and that the third comparison device is designed to be such that a correlation is carried out with a fault pattern consisting of eight angular orientations and a fault message (67) is given in the event of full identity.

6. A test system as claimed in claim 1, characterised in that in the fault administration circuit (22) a fault compression takes place which combines individual fault messages which are locally closely adjacent to form an overall fault corresponding to the field of vision available for visual classification.

7. A test system as claimed in claim 1, characterised in that during the visual classification the faults can be considered in accordance with a specified sequence by push-button operation via the flow control unit (23).

## Revendications

1. Dispositif de contrôle opto-électroque pour l'identification de défauts dans des tracés de voies conductrices d'objets à contrôler se présentant sous la forme de plaquettes de circuits imprimés ou de circuits intermédiaires apparaissant lors de la fabrication de ces plaquettes de circuits imprimés ainsi que des outils à imprimer utilisés à cet effet, comportant

— un convertisseut d'images (6), comme par exemple une ligne de diodes photosensibles,
— un objectif (3) pour la reproduction d'une région de l'objet à contrôler (2) sur le convertisseur d'images (6),
— une platine à chariot croisé (1) supportant l'objet à contrôler (2) pour déplacer l'objet à contrôler (2) suivant des méanders avec une vitesse constante par rapport au convertisseur d'images (6),
— comportant un système de mesure de déplacement associé à la platine à chariot croisé (1),
— comportant un circuit pour produire un signal d'image binaire série à partir du signal de sortie du convertisseur d'images (6), circuit qui comprend un circuit analogique (8) de prétraitement des signaux,
— et comportant également un certain nombre de circuits (11, 12, 13) d'identification de défauts qui sont reliés, en parallèle les uns par rapport aux autres, à la sortie du circuit (8),

caractérisé par

a) un premier circuit (11) d'identification de défauts pour réaliser un contrôle de géométrie minimale par identification de défauts dans les largeurs des voies conductrices et les distances d'isolement, qui comprend les dispositifs suivants:

(i) un premier dispositif de mémorisation (35), recevant le signal d'image, dans les emplacements de mémoire duquel des données de signaux d'image associées aux points d'une section de tracé de voies conductrices peuvent être mémorisées suivant un agencement bidimensionnel correspondant à la section considérée,
(ii) des dispositifs pour la lecture en parallèle des données de signaux d'image existant dans le premier dispositif de mémorisation (35) suivant différentes directions d'une zone de mémorisation,
(iii) des premiers dispositifs comparateurs (36—40) pour comparer les données de signaux d'image lues suivant chaque direction avec des séquences de données prédéterminées.

b) un second circuit (12) d'identification de défauts pour identifier des cosses à souder défectueuses, qui comporte les dispositifs suivants:

(iv) un second dispositif de mémorisation (49) correspondant au premier dispositif de mémorisation et recevant également le signal d'image,
(v) des seconds dispositifs comparateurs (54) pour identifier la présence d'une cosse à souder par comparaison des données de signaux d'image contenues dans le second dispositif de mémorisation (49) avec des modèles de données prédéterminés représentant des cosses à souder sans défaut de différents types,
(vi) des dispositifs (56) pour le contrôle de pastilles identifiées, en ce qui concerne leur forme et leur surface, à l'aide des données de signaux d'image contenues dans le second dispositif de mémorisation (49),

c) un troisième circuit (13) d'identification de défauts pour identifier des courts-circuits (65) ou des interruptions (63) dont l'étendue est plus importante que la largeur minimale des voies conductrices ou que la distance d'isoelement minimale, qui comprend les dispositifs suivants:

(vii) un troisième dispositif de mémorisation (61) correspondant au premier ou au second dispositif de mémorisation (35 ou 49) et recevant le signal d'image,

(vu) un troisième dispositif comparateur (62, 64) pour comparer les données de signaux d'image dans le troisième dispositif de mémorisation (61) avec des modèles de données prédéterminés, qui sont représentatifs de courts-circuits ou d'interruptions dans des voies conductrices orientées différemment,

d) un circuit (22) de mise à jour des défauts se chargeant des messages de défaut des circuits (11, 12, 13) d'identification de défauts, comportant une mémoire pour recevoir les valeurs de coordonnées délivrées par le système de mesure de déplacement lors de l'apparition d'un message de défaut,

e) un circuit de commande (23) au moyen duquel la platine à chariot croisé (1) peut être déplacée dans des positions correspondant aux coordonnées des messages de défaut, ainsi que

f) un dispositif d'observation pour la visualisation des régions d'objet à contrôler qui correspondent aux dites positions.

2. Dispositif de contrôle suivant la revendication 1, caractérisé par le fait qu'en amont du second ainsi que du troisième circuit (12 ou 13) d'identification de défauts est respectivement monté un circuit (20 ou 21) de réduction électronique de la définition.

3. Dispositif de contrôle suivant la revendication 2, caractérisé par le fait que pour la réduction de la définition il est prévu par exemple une zone de dimensions 4 × 4 constituée par des registres à décalage (44), la somme (45) de ses éléments individuels représentant un point d'image réduit, de préférence sous la forme d'une valeur binaire.

4. Dispositif de contrôle suivant la revendication 1, caractérisé par le fait que pour trouver de longues interruptions des voies conductrices le trosième dispositif de mémorisation comporte une zone de dimensions 3 × 3 qui possède un accès en parallèle à une cobinaison de registres à décalage numériques (60) recevant le signal d'image, et le troisième dispositif comparateur est agencé de manière qu'un message de défaut n'ait alors lieu que lorsque seul le point central ou lorsque seul celui-ci et un autre point de la zone peuvent être associés à une voie conductrice.

5. Dispositif de contrôle suivant la revendication 1, caractérisé par le fait que pour l'identification de longs courts-circuits le troisième dispositif de mémorisation comporte une zone de 5 × 5 points d'image qui possède un accès en parallèle à une combinaison de registres à décalage numériques (60) recevant le signal d'image, et que le troisième dispositif comparateur est conçu de manière que soit effectuée une corrélation avec un modèle de défaut, qui existe suivant 8 orientations angulaires, et qu'un message d'erreur (67) soit délivré lors d'une coïncidence totale.

6. Dispositif de contrôle suivant la revendication 1, caractérisé par le fait que dans le circuit (22) de mise à jour des défauts a lieu une compression des défauts qui réunit des messages de défauts individuels étroitement voisins dans l'espace en un défaut global, en correspondance avec le champ de visualisation disponible pour la classification visuelle.

7. Dispositif de contrôle suivant la revendication 1, caractérisé par le fait que dans le cas de la classification visuelle par actionnement de touches, par l'intermédiaire du dispositif (23) de commande de déroulement, les défauts peuvent être observés suivant une séquence déterminée.

FIG 1

0 023 574

FIG 2

FIG 3

$$f = \begin{cases} a & \text{falls } |a| > |b| \\ b & \text{falls } |a| < |b| \end{cases}$$

256  256  256  256  256

I  II  III  IV  V  VI

$a_{m,n-1}$  $a_{m-1,n}$  $a_{m,n}$

FIG 4

FIG 5

# FIG 6

0 023 574

# FIG 7

0 023 574